# EUROPÄISCHE PATENTSCHRIFT

(11) **EP 1 725 883 B1**
(45) Veröffentlichungstag und Bekanntmachung des Hinweises auf die Patenterteilung: **18.09.2013**
(21) Anmeldenummer: 04804520.7
(22) Anmeldetag: 09.11.2004
(51) Int. Cl.: G01R 31/04, H01Q 1/24

(54) **DIAGNOSEVERFAHREN ZUR ÜBERWACHUNG EINER STECKVERBINDUNG**
DIAGNOSTIC METHOD FOR MONITORING A PLUG-IN CONNECTION
PROCEDE DE DIAGNOSTIC POUR LE CONTROLE D'UNE CONNEXION A FICHES

(30) Priorität: 20.12.2003 DE 10360209
(43) Veröffentlichungstag der Anmeldung: 29.11.2006
(73) Patentinhaber: ROBERT BOSCH GMBH, 70442 Stuttgart (DE)
(72) Erfinder: THOLE, Michael, 31139 Hildesheim (DE); JANNSEN, Bert, 31139 Hildesheim (DE); MALZAHN, Thomas, 48429 Rheine (DE)
(86) Internationale Anmeldenummer: PCT/EP2004/052879
(87) Internationale Veröffentlichungsnummer: WO 2005/062063

(56) Entgegenhaltungen:
- WO-A-03/049228
- US-B1- 6 400 334
- US-B1- 6 437 577

## Beschreibung

Die Erfindung betrifft ein Diagnoseverfahren zur Überwachung mindestens einer Steckverbindung zu einer Antenne insbesondere einer Steckverbindung im Antennensignalpfad zu einer Kraftfahrzeug-Scheibenantenne.

### Stand der Technik

Zur Diagnose von Steckverbindern bzw. Steckverbindungen ist es bekannt im Empfänger, z.B. Radio oder TV-Box, ein Stromfenster für einen normalen Betriebsbereich einer aktiven Schaltung im Antennensignalpfad festzulegen. Wenn der Stromverbrauch nicht im vorgegebenen Stromfenster liegt, wird eine Störung signalisiert.

In Dokument US 6 400 334 wird eine entsprechende Diversity antenne für eine Diversity anlange in einem Fahrzaug gezeigt.

### Vorteile der Erfindung

Mit den Maßnahmen des Anspruchs 1, das heißt mit den Schritten:
- ein Diagnosesignal wird über den Antennensignalpfad in Richtung Antenne gespeist,
- an einer im Antennensignalpfad vorgesehenen aktiven Schaltung wird das Diagnosesignal vorbeigeführt,
- in Abhängigkeit davon, ob das Diagnosesignal durch die mindestens eine Steckverbindung eine Störung erfährt wird die Stromversorgung der aktiven Schaltung beeinflusst,
- es wird detektiert, ob der Stromverbrauch der aktiven Schaltung außerhalb eines vorgegebenen Fensters liegt und gegebenenfalls eine Störung signalisiert, können im Gegensatz zu herkömmlichen Lösungen mehr Steckverbindungen diagnostiziert werden, insbesondere die Steckverbindung/die Steckverbinder zur Kfz-Scheibenantenne. Bei herkömmlichen Lösungen wird nur eine Diagnose für den Steckverbinder vom Empfänger zum Impedanzwandler, das heißt zur aktiven Schaltung für die Antennenanpassung, durchgeführt. Eine Diagnose der Steckverbindung zur Scheibenantenne erfolgt nicht oder nur über eine Schleife mit zwei separaten Kontakten.

Bei komplexen Diversity-Systemen ist mit dem Verfahren nach der Erfindung auf einfache Weise ein fehlender Scheibenkontakt festzustellen. Die Erfindung bietet die Möglichkeit bei unterschiedlichen Antennenstrukturen alle Steckverbinder zu überwachen, auch jene einer optional vorgesehenen Diversity-Einrichtung.

Das Verfahren nach der Erfindung zeichnet sich dadurch aus, dass das Diagnosesignal/die Diagnosesignale auf den HF-Antennenanschluss des Empfängers zur Antenne eingespeist werden, das heißt in das HF-Kabel zur Antenne. Somit sind keine zusätzlichen Steckerkontakte notwendig.

Bei Heckscheibenantennen liegt das Heizfeld immer einseitig auf Masse, so dass hier die Detektion einfach über nur einen Steckkontakt möglich ist.

Bei separaten Antennenstrukturen kann eine Detektion über eine Brücke im Scheibenanschlussstecker erfolgen.

### Zeichnungen

Anhand der Zeichnungen werden Ausfübrungsbeispiele der Erfindung erläutert. Es zeigen
Figur 1 ein erstes Ausführungsbeispiel mit einseitig geerdeter Antennenstruktur,
Figur 2 ein alternatives Ausführungsbeispiel für eine beliebige Antennenstruktur,
Figur 3 eine Rückführung des Diagnosesignals zur Stromversorgung einer aktiven Schaltung,
Figur 4 eine Mitüberwachung einer Diversity-Einrichtung,
Figur 5 eine alternative Ausführung zur Mitüberwachung der Diversity-Einrichtung,
Figur 6 eine Alternative zur Mitüberwachung der Diversity-Einrichtung und Auswertung über einen Diagnosewiderstand,
Figur 7 eine weitere Alternative zur Mitüberwachung einer Diversity-Einrichtung.

### Beschreibung von Ausführungsbeispielen

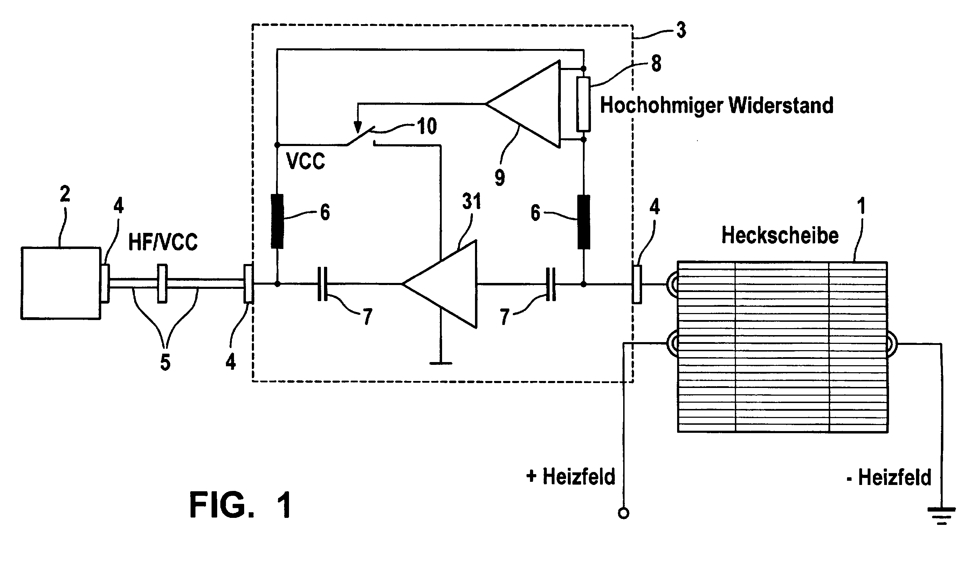

Figur 1 zeigt eine Fahrzeug-Heckscheibe 1, deren Heizdrähte zur Scheibenentfrostung als Antenne benutzt werden. Im Antennensignalpfad zwischen Antenne und Empfänger 2, insbesondere ein Autoradio und/oder eine TV-Box, befindet sich eine Anlennenanpassstufe 3, das heißt ein Impedanzwandler, der hier als aktive Verstärkerschaltung 31 ausgebildet ist. Das Gleichstromspeisesignal für die aktive Schaltung 3 wird gleichzeitig als Diagnosesignal für die Steckverbindungen 4 im Antennensignalpfad benutzt. Es wird über das HF-Kabel 5 zum Impedanzwandler 3 geführt. Hier wird es über die Drosseln 6 im Querzweig und die Kondensatoren 7 im Längszweig abgetrennt und an der aktiven Schaltung 31 vorbeigeführt. Am scheibenseitigen Anschlussende der aktiven Schaltung 31 wird es wieder dem HF-Antennensignal hinzuaddiert. Im Ausführungsbeispiel nach Figur 1 ist das Diagnosesignal im Nebenpfad der aktiven Schaltung 31 über einen insbesondere hochohmigen Diagnosewiderstand 8 von beispielsweise 10 k Ohm geführt.

Die Diagnose der richtigen oder vorhandenen Steckerkontaktierung wird einerseits durch einen Spannungsabfall an einem Diagnosewiderstand 8 detektiert, woraus ein stetiger Stromfluss resultiert. Andererseits durch eine Unterbrechung der Spannungsversorgung. Das Diagnoseverfahren bzw. die Diagnoseeinrichtung nach der Erfindung zeichnet sich dadurch aus, dass die Diagnosesignale auf den HF-Antennenanschluss eingespeist werden und somit keine zusätzlichen Steckerkontakte benötigt werden.

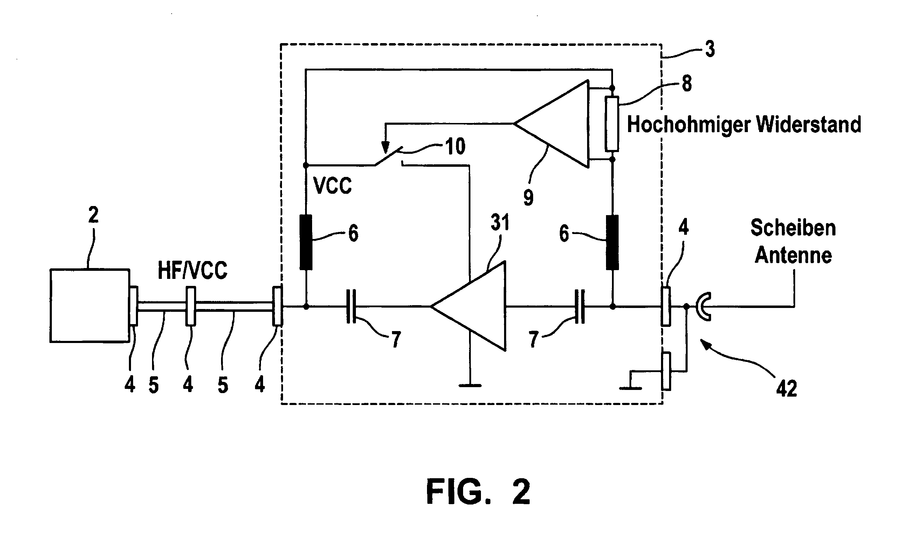

Wenn eine Verbindung nicht gesteckt ist oder der Steckkontakt nicht fehlerfrei ist, wird über den Spannungsabfall an dem hochohmigen Diagnosewiderstand 8 durch die an dem Diagnosewiderstand 8 angeschlossene Auswerteeinheit 9 ein Stromunterbrecher 10 für die aktive Schaltung 31 aktiviert. Durch dieses Abschalten der aktiven Schaltung 31 fließt kein oder nur ein sehr geringer Strom. Dies wird im Empfänger 2 detektiert, das heißt der Stromverbrauch der aktiven Schaltung 31 liegt außerhalb eines vorgegebenen Fensters und es wird eine Störung im Empfänger 2 signalisiert. Bei der in Figur 1 dargestellten Heckscheibenantenne liegt das Heizfeld einseitig auf Masse, so dass hier die Detektion einfach über nur einen scheibenseitigen Steckkontakt möglich ist. Bei separaten Antennenstrukturen gemäß dem in Figur 2 dargestellten Ausführungsbeispiel kann die Detektion über eine Brücke 42 gegen Masse im Scheibenanschlussstecker 4 erfolgen. Die überwachten Steckverbindungen sind in allen Figuren mit einem dunkel ausgefüllten Rechteck gekennzeichnet.

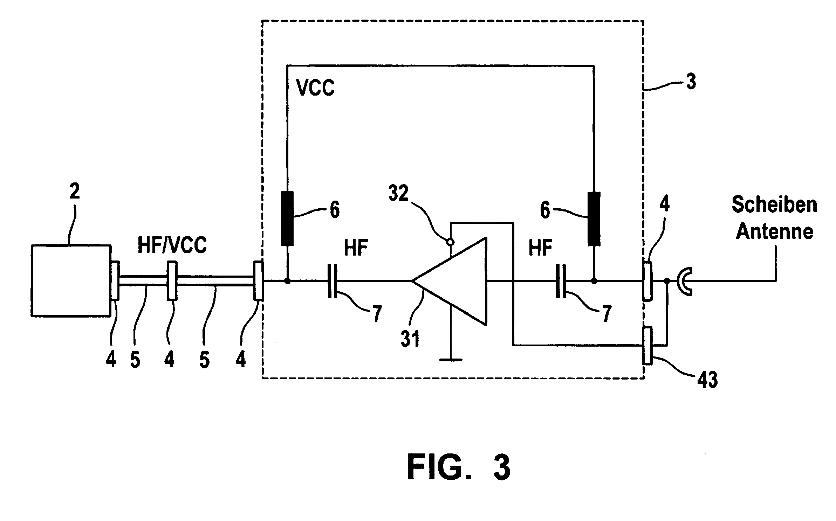

Beim Ausführungsbeispiel gemäß Figur 3 ist der Diagnosewiderstand 8 im Nebenpfad der aktiven Schaltung 31 nicht notwendig, da das Diagnosesignal nach Durchlaufen des scheibenseitigen Steckverbinders über die Brücke 43 zum Stromversorgungsanschluss 32 der aktiven Schaltung 31 rückgeführt ist.

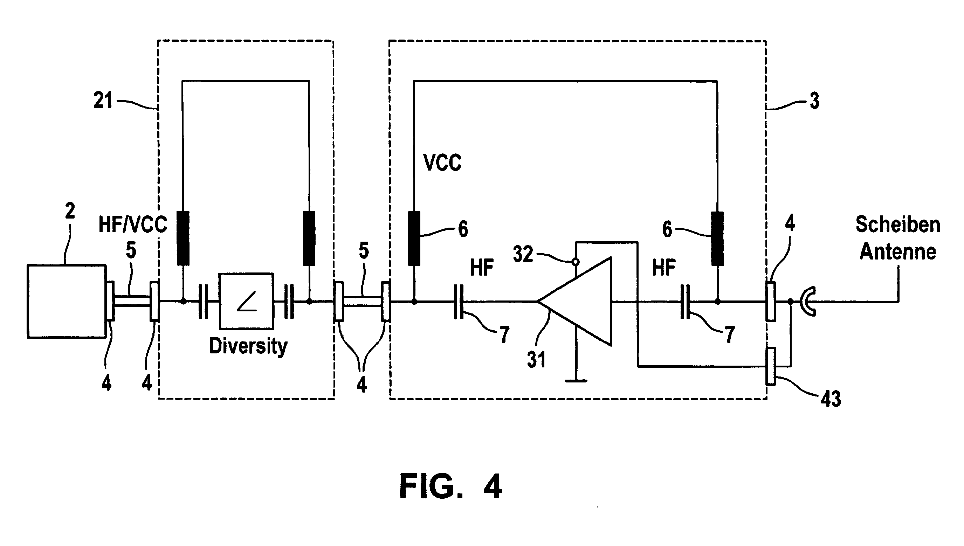

Bei Ausführungsbeispiel gemäß Figur 4 werden die Steckverbindungen der der Anpassstufe 3 vorgeschalteten Diversity-Einrichtung 21 mit überwacht. Das Diagnosesignal wird auch hier phantomgespeist über das HF-Kabel 5 des Antennensignalpfades und wird am Eingang der Diversity-Einrichtung 21 abgetrennt, an der aktiven Schaltung der Diversity-Einrichtung 21 vorbeigeleitet und am Ausgang der HF-Signal wieder zugesetzt.

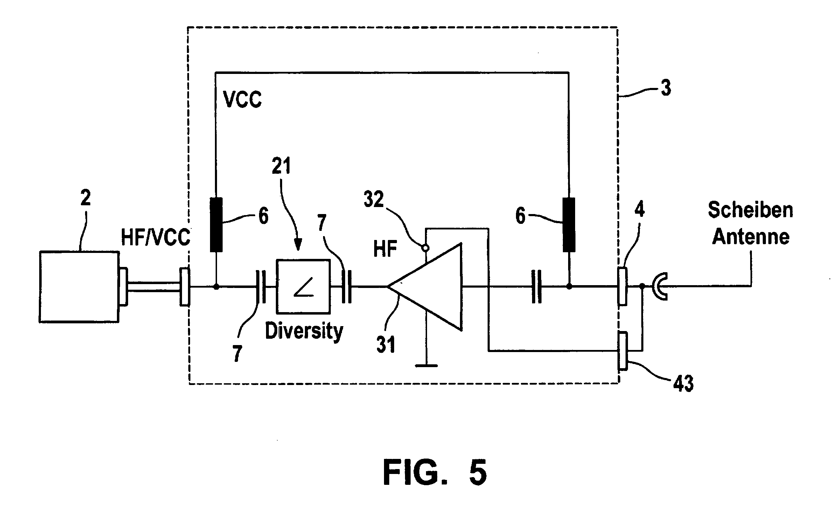

Figur 5 zeigt eine Diversity-Einrichtung 21 mit integrierter (nachgeschalteter) Anpassstufe. Das Diagnosesignal wird hier am Eingang der Diversity-Einrichtung 21 abgetrennt, an der/den aktiven Schaltung/en der Diversity-Einrichtung und der Anpassstufe 3 vorbei bis zum scheibenseitigen Ausgang der Anpassstufe geleitet und dort dem HF-Signal wieder zugesetzt.

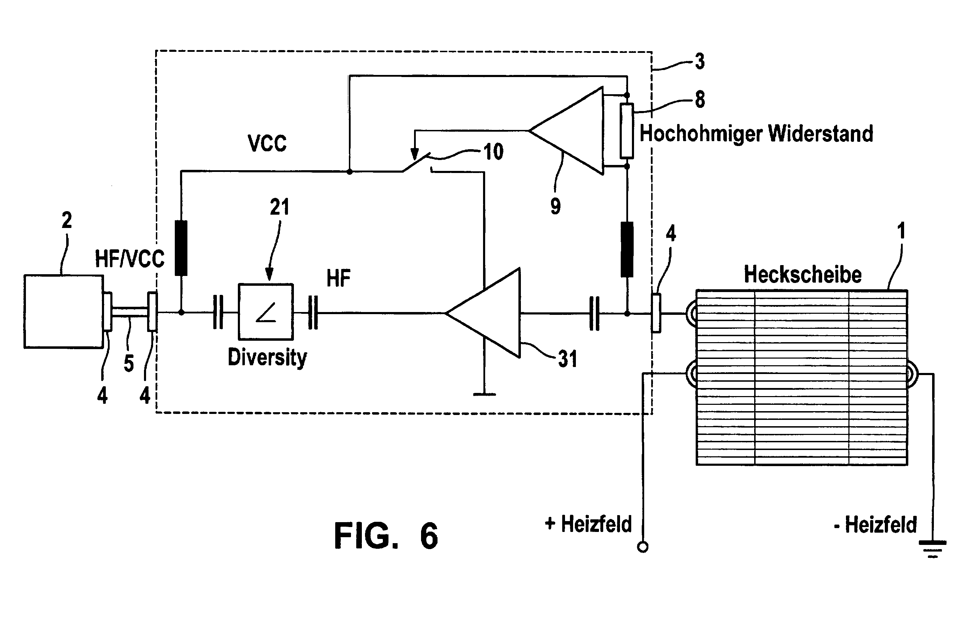

Figur 6 zeigt eine Alternative zu Figur 5 mit integrierter Diversity-Einrichtung. Hier ist wie in Figur 1 der Diagnosewiderstand 8 mit Auswerteeinheit 9 und Stromversorgungsunterbrecher 10 als Alternative zur Rückführung des Diagnosesignals über eine Brücke am scheibenseitigen Steckverbinder vorgesehen.

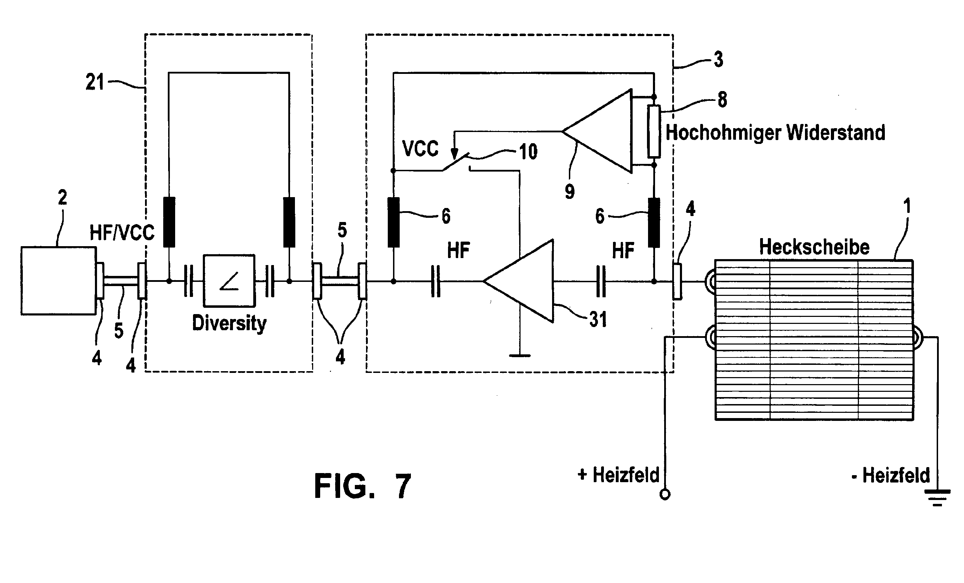

Figur 7 zeigt die Vorbeileitung des Diagnosesignals an der aktiven Schaltung der vorgeschalteten Diversity-Einrichtung und die Auswertung des Spannungsabfalls an entsprechend Figur 1 vorgesehenen Diagnosewiderstand 8 in der Anpassschaltung 3.

## Patentansprüche

1. Diagnoseverfahren zur Überwachung mindestens einer Steckverbindung zu einer Antenne insbesondere einer Steckverbindung im Antennensignalpfad zu einer Kraftfahrzeug-Scheibenantenne mit folgenden Schritten:
- ein Diagnosesignal wird über den Antennensignalpfad in Richtung Antenne (1) eingespeist,
- an einer im Antennensignalpfad vorgesehenen aktiven Schaltung (31) wird das Diagnosesignal vorbeigeführt,
- in Abhängigkeit davon, ob das Diagnosesignal durch die mindestens eine Steckverbindung (4) eine Störung erfährt, wird die Stromversorgung der aktiven Schaltung (31) beeinflusst,
- es wird detektiert, ob der Stromverbrauch der aktiven Schaltung (31) außerhalb eines vorgegebenen Fensters liegt und gegebenenfalls eine Störung signalisiert.

2. Diagnoseverfahren nach Anspruch 1, **dadurch gekennzeichnet, dass** als Diagnosesignal das Gleichstromspeisesignal für die aktive Schaltung (31) verwendet wird.

3. Diagnoseverfahren nach Anspruch 1 oder 2, **dadurch gekennzeichnet, dass** das Diagnosesignal über einen Diagnosewiderstand (8) geführt wird, dass der Spannungsabfall am Diagnosewiderstand (8) überwacht wird und dass bei einer Störung an der mindestens einen Steckverbindung (4) über den Spannungsabfall am Diagnosewiderstand (8) ein Stromversorgungsunterbrecher (10) für die aktive Schaltung (31) aktiviert wird.

4. Diagnoseverfahren nach Anspruch 1 oder 2, **dadurch gekennzeichnet, dass** das Diagnosesignal nach Durchlaufen der antennenseitigen Steckverbindung (4) zur aktiven Schaltung (31) rückgeführt wird und zwar zu deren Stromversorgungsanschluss (32).

5. Diagnoseverfahren nach einem der Ansprüche 1 bis 4, **dadurch gekennzeichnet, dass** das Diagnosesignal an einer im Antennensignalpfad vorgesehenen Diversity-Einrichtung (21) vorbeigeführt wird und anschließend wieder in den Antennensignalpfad eingespeist wird.

6. Diagnoseverfahren nach einem der Ansprüche 1 bis 5, **dadurch gekennzeichnet, dass** das Diagnosesignal über den Antennensignalpfad bzw. dessen HF-Kabel (5) phantomgespeist wird.

7. Diagnoseeinrichtung zur Überwachung mindestens einer Steckverbindung zu einer Antenne, insbesondere einer Steckverbindung im Antennensignalpfad zu einer Kraftfahrzeug-Scheibenantenne mit folgenden Merkmalen:
- Mitteln zur Generierung eines Diagnosesignals und zur Einspeisung in den Antennensignalpfad in Richtung Antenne (1),
- Mitteln zur Vorbeiführung des Diagnosesignals an einer aktiven Schaltung (31) im Antennensignalpfad (31),
- Mitteln zur Beeinflussung der Stromversorgung der aktiven Schaltung (31) in Abhängigkeit davon, ob das Diagnosesignal durch die mindestens eine Steckverbindung (4) eine Störung erfährt,
- Mitteln zur Detektion des Stromverbrauchs der aktiven Schaltung (31) und zur Signalisierung einer Störung, wenn der Stromverbrauch außerhalb eines vorgegebenen Fensters liegt.

8. Diagnoseeinrichtung nach Anspruch 7, **dadurch gekennzeichnet, dass** ein Diagnosewiderstand (8) im Vorbeiführungszweig der aktiven Schaltung (31) vorgesehen ist, dass der Diagnosewiderstand (8) mit einer Auswerteeinheit (9) verbunden ist mittels derer ein Stromversorgungsunterbrecher (19) für die aktive Schaltung (31) betätigbar ist.

9. Diagnoseeinrichtung nach Anspruch 7 oder 8, **dadurch gekennzeichnet, dass** Mittel vorgesehen sind zur Rückführung des Diagnosesignals nach Durchlaufen der antennenseitigen Steckverbindung (4, 43) zu einem Stromversorgungsanschluss (32) der aktiven Schaltung (31).

10. Diagnoseeinrichtung nach einem der Ansprüche 7 bis 9, **dadurch gekennzeichnet, dass** eine Phantomspeisung des Diagnosesignals, welches insbesondere das Gleichstromspeisesignal für die aktive Schaltung (31) ist, über den Antennensignalpfad bzw. dessen HF-Kabel (5) vorgesehen ist.

## Claims

1. Diagnostic method for monitoring at least one plug-in connection to an antenna, in particular a plug-in connection in the antenna signal path to a motor vehicle windowpane antenna, having the following steps:
- a diagnostic signal is fed in in the direction of the antenna (1) via the antenna signal path,
- the diagnostic signal is guided past an active circuit (31) provided in the antenna signal path,
- the power supply for the active circuit (31) is influenced depending on whether the diagnostic signal experiences interference as a result of the at least one plug-in connection (4),
- it is detected whether the power consumption of the active circuit (31) is outside a predefined window and possibly signals interference.

2. Diagnostic method according to Claim 1, **characterized in that** the direct current feed signal for the active circuit (31) is used as the diagnostic signal.

3. Diagnostic method according to Claim 1 or 2, **characterized in that** the diagnostic signal is guided via a diagnostic resistor (8), **in that** the voltage drop across the diagnostic resistor (8) is monitored, and **in that** a power supply interrupter (10) for the active circuit (31) is activated in the event of interference in the at least one plug-in connection (4) via the voltage drop across the diagnostic resistor (8).

4. Diagnostic method according to Claim 1 or 2, **characterized in that**, after passing through the plug-in connection (4) on the antenna side, the diagnostic signal is fed back to the active circuit (31), to be precise to the power supply connection (32) of the latter.

5. Diagnostic method according to one of Claims 1 to 4, **characterized in that** the diagnostic signal is guided past a diversity device (21) provided in the antenna signal path and is then fed into the antenna signal path again.

6. Diagnostic method according to one of Claims 1 to 5, **characterized in that** the diagnostic signal is phantom-fed via the antenna signal path or its RF cable (5).

7. Diagnostic device for monitoring at least one plug-in connection to an antenna, in particular a plug-in connection in the antenna signal path to a motor vehicle windowpane antenna, having the following features:
- means for generating a diagnostic signal and for feeding said signal into the antenna signal path in the direction of the antenna (1),
- means for guiding the diagnostic signal past an active circuit (31) in the antenna signal path (31),
- means for influencing the power supply for the active circuit (31) on the basis of whether the diagnostic signal experiences interference as a result of the at least one plug-in connection (4),
- means for detecting the power consumption of the active circuit (31) and for signalling interference if the power consumption is outside a predefined window.

8. Diagnostic device according to Claim 7, **characterized in that** a diagnostic resistor (8) is provided in the guiding-past branch of the active circuit (31), **in that** the diagnostic resistor (8) is connected to an evaluation unit (9) which can be used to actuate a power supply interrupter (19) for the active circuit (31).

9. Diagnostic device according to Claim 7 or 8, **characterized in that** means are provided for feeding the diagnostic signal back to a power supply connection (32) of the active circuit (31) after passing through the plug-in connection (4, 43) on the antenna side.

10. Diagnostic device according to one of Claims 7 to 9, **characterized in that** phantom feeding of the diagnostic signal, which is the direct current feed signal for the active circuit (31) in particular, is provided via the antenna signal path or its RF cable (5).

## Revendications

1. Procédé de diagnostic pour surveiller au moins une connexion enfichée vers une antenne, notamment une connexion enfichée dans le chemin du signal d'antenne vers une antenne de pare-brise de véhicule automobile, comprenant les étapes suivantes :
- un signal de diagnostic est injecté en direction de l'antenne (1) par le biais du chemin du signal d'antenne,
- le signal de diagnostic est acheminé à un circuit actif (31) prévu dans le chemin du signal d'antenne,
- l'alimentation électrique du circuit actif (31) est influencée en fonction d'un défaut provoqué ou non au signal de diagnostic par l'au moins une connexion enfichée (4),
- il est détecté si la consommation électrique du circuit actif (31) se trouve en-dehors d'un créneau prédéfini et un défaut est signalé le cas échéant.

2. Procédé de diagnostic selon la revendication 1, **caractérisé en ce que** le signal de diagnostic utilisé est le signal d'alimentation en courant continu pour le circuit actif (31).

3. Procédé de diagnostic selon la revendication 1 ou 2, **caractérisé en ce que** le signal de diagnostic passe par une résistance de diagnostic (8), **en ce que** la chute de tension aux bornes de la résistance de diagnostic (8) est surveillée et **en ce que** dans le cas d'un défaut au niveau de l'au moins une connexion enfichée (4), un interrupteur d'alimentation électrique (10) pour le circuit actif (31) est activé par le biais de la chute de tension aux bornes de la résistance de diagnostic (8).

4. Procédé de diagnostic selon la revendication 1 ou 2, **caractérisé en ce que** le signal de diagnostic retourne vers le circuit actif (31), à savoir vers sa borne d'alimentation électrique (32), après être passé à travers la connexion enfichée (4) côté antenne.

5. Procédé de diagnostic selon l'une des revendications 1 à 4, **caractérisé en ce que** le signal de diagnostic est acheminé à un dispositif à diversité (21) prévu dans le chemin du signal d'antenne et il est ensuite de nouveau injecté dans le chemin du signal d'antenne.

6. Procédé de diagnostic selon l'une des revendications 1 à 5, **caractérisé en ce que** le signal de diagnostic est injecté en tant que signal fantôme par le biais du chemin du signal d'antenne ou de son câble HF (5).

7. Dispositif de diagnostic pour surveiller au moins une connexion enfichée vers une antenne, notamment une connexion enfichée dans le chemin du signal d'antenne vers une antenne de pare-brise de véhicule automobile, ayant les caractéristiques suivantes :
- des moyens pour générer un signal de diagnostic et pour l'injecter dans le chemin du signal d'antenne en direction de l'antenne (1),
- des moyens pour acheminer le signal de diagnostic à un circuit actif (31) dans le chemin du signal d'antenne (31),
- des moyens pour influencer l'alimentation électrique du circuit actif (31) en fonction d'un défaut provoqué ou non au signal de diagnostic par l'au moins une connexion enfichée (4),
- des moyens pour détecter la consommation électrique du circuit actif (31) et pour signaler un défaut lorsque la consommation électrique se trouve en-dehors d'un créneau prédéfini.

8. Dispositif de diagnostic selon la revendication 7, **caractérisé en ce qu'**il est prévu une résistance de diagnostic (8) dans la branche d'acheminement du circuit actif (31), **en ce que** la résistance de diagnostic (8) est reliée à une unité d'interprétation (9) au moyen de laquelle peut être actionné un interrupteur d'alimentation électrique (10) pour le circuit actif (31).

9. Dispositif de diagnostic selon la revendication 7 ou 8, **caractérisé en ce que** des moyens sont prévus pour renvoyer le signal de diagnostic après qu'il soit passé à travers la connexion enfichée (4, 43) côté antenne vers une borne d'alimentation électrique (32) du circuit actif (31).

10. Dispositif de diagnostic selon l'une des revendications 7 à 9, **caractérisé en ce qu'**une injection fantôme du signal de diagnostic, lequel est notamment le signal d'alimentation en courant continu pour le circuit actif (31), est prévue par le biais du chemin du signal d'antenne ou de son câble HF (5).
